(19) Europäisches Patentamt
European Patent Office
Office européen des brevets

(11) **EP 1 806 868 A1**

(12) **DEMANDE DE BREVET EUROPEEN**

(43) Date de publication:
**11.07.2007 Bulletin 2007/28**

(51) Int Cl.:
*H04L 9/18* (2006.01)    *H04L 1/00* (2006.01)

(21) Numéro de dépôt: **07290010.3**

(22) Date de dépôt: **04.01.2007**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **05.01.2006  FR 0600081**

(71) Demandeur: **ETAT-FRANCAIS représenté par le Délégué Général pour l' Armement**
**94114 Arcueil Cedex (FR)**

(72) Inventeurs:
• **Barbier, Johann**
  **35580 Guichen (FR)**
• **Caillard, Paul-Emmanuel**
  **35000 Rennes (FR)**

(54) **Procédés d'émission et de réception d'un message numérique  et dispositifs associés**

(57) L'invention concerne un procédé et un dispositif associé pour envoyer des données D entre un émetteur et un ou plusieurs récepteurs à travers un canal. Elle a notamment plus particulièrement pour objet un procédé d'émission d'un message numérique utilisant un émetteur comportant au moins des moyens de stockage d'information et des moyens de traitement des données, caractérisé en ce qu'il comporte au moins une étape de codage de données D, constituant tout ou partie dudit message numérique, et consistant à déterminer une permutation Pc dont les coefficients sont, au moins en partie, fonction des données D.

```
┌──────────────────────────────────────┐
│   Codage par une permutation de      │
│   l'information à transmettre        │
└──────────────────────────────────────┘
                  │
                  ▼
┌──────────────────────────────────────┐
│  Génération, modulation et envoi dans │
│   le canal des paquets à transmettre  │
└──────────────────────────────────────┘
                  │
                  ▼
┌──────────────────────────────────────┐
│ Réception et traitement de suffisamment│
│       de parties de paquets          │
└──────────────────────────────────────┘
                  │
                  ▼
┌──────────────────────────────────────┐
│  Reconstruction de la permutation et  │
│  extraction des données transmises    │
└──────────────────────────────────────┘
```

Fig.4

**Description**

L'invention concerne un procédé et un dispositif associé pour envoyer des données D entre un émetteur et un ou plusieurs récepteurs à travers un canal. La transmission à travers le canal résiste aux effacements, aux pertes de paquets, et fonctionne pour un canal synchronisé quelconque, même s'il est de caractéristiques inconnues de l'émetteur, ou imprévisibles.

La transmission de données à travers un canal nécessite habituellement de connaître le canal pour adapter le codage aux caractéristiques de celui-ci. Si les caractéristiques du canal ne sont pas connues de l'émetteur, celui-ci envoie les données avec un codage adapté au canal supposé qui n'est pas le canal réel. Si ce canal réel est moins bruité que le canal supposé, le récepteur pourra décoder l'information, mais la quantité de données envoyées sera plus faible que si le codage est adapté au canal. Si le canal réel est plus bruité que le canal supposé, le récepteur sera incapable de décoder l'information, ou bien le taux de paquets ayant des erreurs sera important.
Par ailleurs si un ou plusieurs paquets ne parviennent pas au récepteur, il ne pourra pas retrouver le message original, sauf si les paquets perdus sont émis à nouveau, ou si le codage correcteur utilisé est très redondant. De même, en cas d'effacement de certains bits, si la capacité de correction du codage correcteur d'erreurs est dépassée, les données envoyées ne peuvent plus être retrouvées.

Les systèmes classiques de codage correcteur d'erreurs sont optimisés pour donner de bons résultats sur le taux d'erreur binaire, et non pas sur le taux d'erreur par paquets, ou pour un ensemble de données. Il faut donc leur adjoindre un mécanisme détecteur d'erreurs, qui permet d'exclure les paquets ayant des erreurs après décodage. Si un paquet contient des erreurs après décodage, il n'est pas exploité et les informations transmises sont toutes perdues. Elles doivent alors être envoyées de nouveau.

Dans le domaine des télécommunications, on connaît par exemple le protocole IS-130 qui consiste en un codage 5/6 où, pour chaque groupe de 5 bits de données, un sixième bit est introduit pour corriger les erreurs. Cependant, une telle redondance est superflue lorsque la transmission n'est pas ou peu bruitée et elle est insuffisante lorsque le canal est très bruité c'est-à-dire lorsque le ratio du signal sur le bruit est faible.

Pour résoudre cet inconvénient, la demande de brevet EP0960495 décrit un procédé de redondance incrémentale consistant, à partir d'un code correcteur d'erreurs donné, de rendement fixe, par exemple 5/6, d'envoyer progressivement des bits de redondance. Si l'information n'a pas pu être décodée, le reste de la redondance est envoyée par petites parties jusqu'à ce que l'information puisse être décodée.
Ainsi, sur un canal de transmission peu bruité le taux de redondance sera faible tandis qu'il sera important pour un canal de transmission très bruité.
Cependant un tel procédé a l'inconvénient d'avoir un rendement minimum qui doit être compatible avec la capacité du canal.
Le but de l'invention est de proposer un procédé de codage ne présentant pas un tel inconvénient et permettant d'envoyer de l'information à travers un canal alors que les caractéristiques du canal (niveau et type de bruit) ne sont pas connues de l'émetteur.
L'invention concerne tout d'abord un procédé d'émission d'un message numérique utilisant un émetteur comportant au moins des moyens de stockage d'information et des moyens de traitement des données, caractérisé en ce qu'il comporte au moins une étape de codage de données D, constituant tout ou partie dudit message numérique, et consistant à déterminer une permutation Pc dont les coefficients sont, au moins en partie, fonction des données D.
Un procédé selon l'invention comporte, en outre, au moins l'une des caractéristique suivantes :

- les données D comportent Z bits et la permutation Pc est de longueur N, avec $Z \leq \log_2(N\,!)$,
- une étape de codage est effectuée par une application inversible C apte à associer, aux dites données D, une permutation Pc,
- la permutation PC peut être prise de longueur N+k, k indices étant gardé pour coder un motif de détection d'erreurs,
- une étape de génération de $(B_1, B_2, ..., B_n)$ prédéfinies ou définies en synchronisation avec le récepteur.
- une étape où les séquences $(B_1, B_2, ..., B_n)$ sont permutées par la permutation Pc. Les séquences de bits $(B_1, B_2, ..., B_n)$ permutées seront aussi appelés « les permutés » dans la suite et notés $(B_{1'}, B_{2'}, .... B_{n'})$.
- Une étape où les permutés subissent, éventuellement, une seconde permutation pseudo-aléatoire P et/ou un code correcteur avant leur transmission par l'émetteur,
- Une étape où les permutés sont modulés en symboles adaptés au canal de transmission,
- Une étape de transmission des symboles codant les permutés à travers une modulation portant sur une ou plusieurs fréquences porteuses, chaque fréquence porteuse utilisant des séquences de bits permutées distinctes et permutées par la même permutation Pc,

Dans le cas où les permutés ne peuvent pas être envoyés dans leur totalité dans une trame du canal, ils peuvent être transmis par morceaux, chaque morceau étant envoyé dans une trame différente ou non envoyés dans leur totalité dans la trame, la partie envoyée étant par exemple tirée aléatoirement dans les permutés.

Un procédé d'émission peut alors comporter au moins l'une des étapes suivantes :

- une étape de transmission des permutés, par morceaux, chaque morceau étant envoyé dans une trame différente,
- une étape dans laquelle les séquences de bits permutés ne sont pas envoyées dans leur totalité, la partie envoyée étant par exemple tirée aléatoirement

L'invention concerne par ailleurs, un procédé de réception d'un message numérique utilisant un récepteur comportant au moins des moyens de stockage d'information et des moyens de traitement de données, caractérisé en ce qu'il comporte au moins une des caractéristiques suivantes :

- une étape de réception de séquences ($R_1$, $R_2$, ..., $R_n$),
- une étape de détermination des coefficients d'une permutation Pc à partir de ces séquences et des séquences de bits ($B_1$, $B_2$, ..., $B_n$) prédéfinies ou définies en synchronisation avec un émetteur, lesdites séquences reçues ($R_1$, $R_2$, ..., $R_n$) correspondant respectivement aux séquences ($B_1$, $B_2$, ..., $B_n$) mais ayant été permutées par la permutation Pc. Cette étape est réalisée par n'importe quel algorithme de reconstruction de permutation,
- une étape de décodage d'une permutation Pc pour retrouver des données D. Cette étape est réalisée par l'application inverse de C, i.e. $C^{-1}$,
- la permutation Pc, les séquences reçues ($R_1$, $R_2$, ..., $R_n$) et les séquences prédéfinies ou définies ($B_k$, $R_k$) sont du même ordre, à savoir d'ordre N,
- le nombre n de séquences reçues ($R_1$, $R_2$, ..., $R_n$) est au moins égal à $\log_2(N)$,
- le procédé de réception pouvant comporter une étape de décodage et/ou de désentrelacement si une seconde permutation pseudo-aléaroire et/ou un codage correcteur d'erreurs a été utilisé par l'émetteur,
- le procédé de réception pouvant comporter une étape de détection d'erreurs pour la permutation reconstruite Pc lorsque Pc est de longueur N+k et si k indices de Pc sont un motif de détection d'erreurs

En d'autres termes, un procédé d'émission et de réception de données numérique selon l'invention peut consister à :

- coder par une permutation Pc le message numérique D de l'information à transmettre,
- générer des séquences ($B_1$, $B_2$, ..., $B_n$), les permuter par la permutation Pc puis les transmettre,
- recevoir suffisamment de paquets $R_i$ transmis par l'émetteur,
- reconstruire la permutation Pc à partir de ces paquets et des permutés puis extraire le message numérique D.

L'invention concerne aussi un dispositif d'émission de données apte à mettre en oeuvre un procédé d'émission selon l'invention et comportant au moins des moyens de stockage d'informations et des moyens de traitement d'information, caractérisé en ce qu'il comporte des moyens aptes à coder de l'information D en une permutation Pc et à générer des séquences de bits ($B_1$, $B_2$, ..., $B_n$) prédéfinies ou définies en synchronisation avec un récepteur et à les permuter par la permutation Pc.

Selon une caractéristique additionnelle, le dispositif d'émission peut comporter un générateur pseudo-aléatoire pour générer les séquences ($B_1$, $B_2$, ..., $B_n$).

L'invention concerne aussi un dispositif de réception de données apte à mettre en oeuvre un procédé de réception selon l'invention et comportant au moins des moyens de stockage d'information et des moyens de traitement d'information, caractérisé en ce qu'il comporte des moyens aptes à déterminer des coefficients d'une permutation Pc à partir de séquences de bits reçues ($R_1$, $R_2$, ..., $R_n$) et de séquences de bits ($B_1$, $B_2$, ..., $B_n$) prédéfinies ou définies en synchronisation avec un émetteur, lesdites séquences reçues ($R_1$, $R_2$, ..., $R_n$) correspondant respectivement aux séquences ($B_1$, $B_2$, ..., $B_n$) mais ayant été permutées par la permutation Pc et apte à décoder la permutation Pc pour retrouver l'information D.

Selon une caractéristique additionnelle, le dispositif de réception peut comporter un générateur pseudo-aléatoire pour générer les séquences ($B_1$, $B_2$, ..., $B_n$).

Le récepteur mettra un temps plus ou moins long pour recevoir le signal en fonction du bruit, mais il parviendra toujours à retrouver les données D, sauf si le bruit est tel que la capacité du canal est nulle. Le récepteur pourra aussi retrouver les données D si la réception du signal subit des interruptions : il suffit que la quantité d'information reçue soit suffisante.

Le récepteur peut enfin recevoir l'information à partir de plusieurs canaux qui émettent en parallèle. Dans l'hypothèse où chaque canal envoie des signaux différents, le récepteur pourra exploiter tous les canaux simultanément et recevra l'information le plus rapidement possible. L'invention permet au récepteur de retrouver l'information dès que la quantité d'information qui parvient au récepteur est suffisante, peu importe quel paquet d'information il a pu exploiter. L'invention est donc vraiment adaptée aux liaisons exploitant de la diversité, spatiale (plusieurs antennes) ou fréquentielle (utilisation d'un spectre large comme l'OFDM ou le FDMA).

L'invention est optimisée pour retrouver un ensemble de données : ou bien le récepteur a reçu assez d'information et il retrouve l'ensemble des données émises sans erreur, ou bien il n'a pas reçu assez d'information et ne retrouve qu'une partie de l'information : les performances attendues d'un système de télécommunication envoyant des données concernent plus le taux d'erreurs par paquet, optimisé dans l'invention, que le taux d'erreurs par bit.

Quel que soit le rendement, seule la quantité de données reçues nécessaire pour retrouver l'information émise évolue en fonction du bruit.

Selon une caractéristique particulière de l'invention, les données sont émises par un ou plusieurs émetteurs, à un ou plusieurs récepteurs, à travers un ou plusieurs canaux. La qualité des canaux utilisés n'est pas connue a priori.

Une permutation de taille N est une fonction bijective entre deux ensembles de cardinal N. On supposera ici que les deux ensembles sont les entiers compris entre 1 et N inclus. Pour faire fonctionner le procédé de l'invention, il faut disposer d'un algorithme de codage et décodage de l'information par une permutation, d'un algorithme de reconstruction de permutation, et d'une suite de bits Sb suffisamment longue connue du récepteur et de l'émetteur. Cette suite peut être choisie parmi un panel plus ou moins large de suites connues par l'émetteur et le récepteur ou générée à l'aide d'un générateur pseudo aléatoire connu et synchronisé entre le récepteur et l'émetteur.

Au cours de l'étape de codage, une application inversible C les données D à transmettre sont codées par une permutation Pc de taille adaptée. Avant la transmission, cette permutation Pc n'est connue que de l'émetteur. Le récepteur devra la reconstruire à partir des informations qu'il recevra. Une permutation de taille N permet d'envoyer au plus $\log_2$(N!) bits de données. Cette étape est effectuée à chaque fois que de nouvelles données doivent être envoyées.

Au cours de l'étape de génération d'un paquet, au moins n séquences, $B_1$, B2, ... $B_n$ de N bits de la longueur N de la permutation Pc , avec n au moins égal à $\log_2$(N), est extraite de Sb par l'émetteur. Idéalement ces séquences $B_1$, $B_2$,... $B_n$ possèdent autant de 0 que de 1, et ont des propriétés proches de l'aléa. Chacune de ces séquences $B_1$, $B_2$,... $B_n$ est mélangée par la permutation Pc issue de l'étape de codage de l'information D. Il en résulte de nouvelles séquences $B'_1$, $B'_2$,... $B'_n$ de N bits B' qui sont préférentiellement à nouveau mélangées par une permutation P, connue de l'émetteur et du récepteur. Les séquences de N bits ainsi obtenues sont notées $B''_1$, $B''_2$,... $B''_n$. La permutation P peut être fixe, ou changer à chaque paquet c'est-à-dire pour chaque séquence. Ces séquences $B''_1$, $B''_2$,... $B''_n$ sont ensuite éventuellement codées à l'aide d'un code correcteur d'erreurs, et modulées, pour former des séquences $S_1$, $S_2$,... $S_n$ de symboles adaptées au canal. Ces séquences S sont alors envoyées à travers le canal. Au moins $\log_2$(N) séquences $B_1$, $B_2$,... $B_n$ différentes sont nécessaires pour que le récepteur ait assez d'éléments pour reconstruire la permutation Pc qu'il ne connaît pas. La transmission des séquences $S_1$, $S_2$,... $S_n$ peut être faite simultanément sur plusieurs canaux de transmission, mais pour chaque canal la séquence B générée doit être différente pour exploiter au mieux la transmission.

Lors de la réception, le récepteur démodule les paquets reçus, applique, le cas échéant, le décodage correcteur d'erreurs, et corrige le cas échéant certaines erreurs dues au canal. Il applique ensuite la permutation inverse de P, connue. A l'aide des séquences $B_1$, $B_2$,... $B_n$ extraites de Sb dans les mêmes conditions et selon les mêmes critères que l'émetteur, il alimente l'algorithme de reconstruction de la permutation Pc, en précisant éventuellement la confiance qu'il a dans les informations reçues. Cette étape est répétée tant que le récepteur n'a pas réussi à reconstruire cette permutation.

Au cours de la dernière étape, le récepteur applique, à la permutation Pc ainsi reconstruite un algorithme de décodage $C^{-1}$ qui correspond à l'application inverse de C et il en déduit les données D qui ont été codées par cette permutation. Le récepteur vérifie éventuellement à l'aide d'un motif de détection d'erreurs que les données n'ont pas été modifiées lors de la transmission. S'il existe une voie retour, il peut envoyer un acquittement à l'émetteur, qui peut alors envoyer de nouvelles données.

L'invention et les avantages qui en découlent apparaîtront plus clairement à la lecture de la description qui suit. Un premier exemple de mise en oeuvre concerne un système de diffusion de l'information sans voie retour. Plusieurs variantes du procédé d'envoi de l'information entre un émetteur et un ou plusieurs récepteurs à travers un canal seront ensuite données. La description est à lire en référence aux dessins annexés dans lesquels :

- la figure 1 est un schéma bloc d'un mode de réalisation d'une architecture d'un système comprenant les deux dispositifs dans lesquels est implémenté le procédé de l'invention,
- la figure 2 présente un dispositif émetteur selon un mode de réalisation de l'invention,
- la figure 3 présente un dispositif récepteur émetteur selon un mode de réalisation de l'invention,

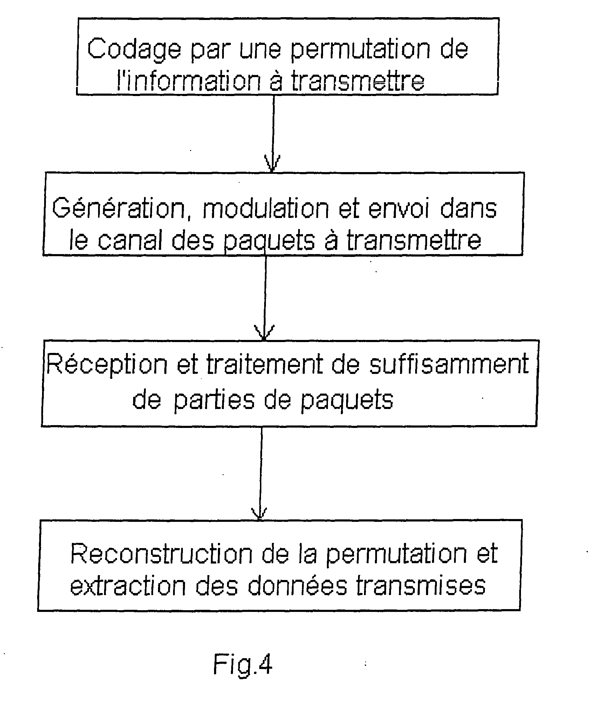

- la figure 4 est un diagramme d'un procédé selon l'invention.

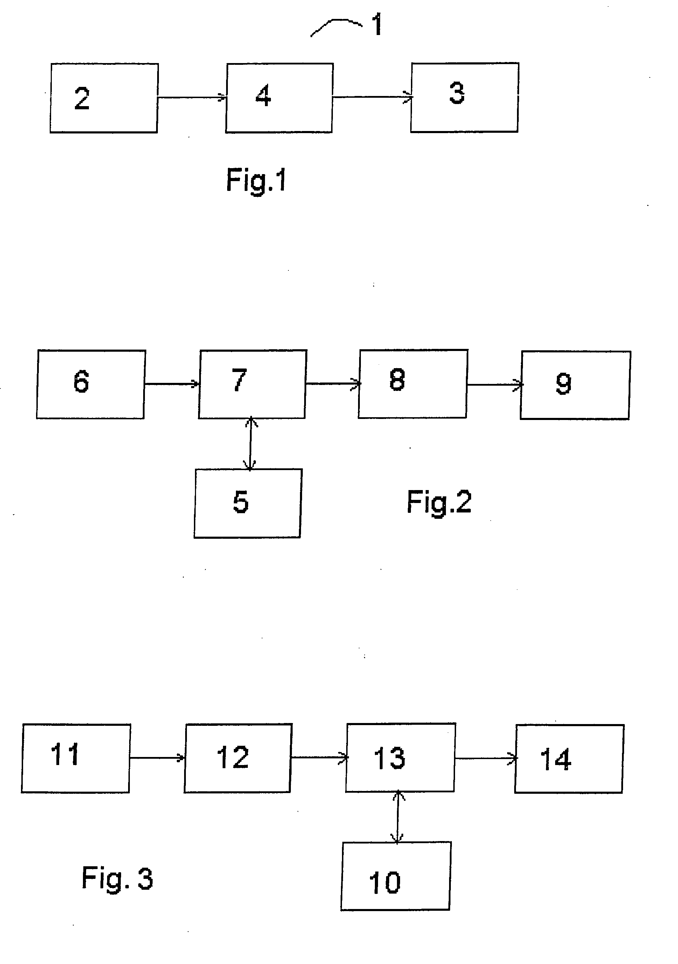

La figure 1 représente, sous forme de schéma bloc, un dispositif électronique de télécommunication (1) apte à mettre en oeuvre un procédé de codage et transmission de l'information selon l'invention. Dans ce mode de réalisation, le dispositif (1) contient deux équipements, l'équipement émetteur (2) et l'équipement récepteur (3) reliés par un canal de transmission (4).

La figure 2 représente sous forme de schéma bloc la réalisation de l'émetteur (2). L'émetteur est un équipement électronique, contenant des moyens de stockage d'information et des moyens de traitement de données aptes à effectuer des calculs programmés. L'émetteur comprend une unité centrale (7), capable d'effectuer des opérations de calculs programmés. Elle est reliée à une ou plusieurs mémoires (5), et à un générateur pseudo-aléatoire (6) capable de générer un flux pseudo-aléatoire ayant les mêmes propriétés statistiques que l'aléa. Les données à diffuser au récepteur sont contenues dans la mémoire (5) de l'émetteur. L'unité centrale (7) génère selon le procédé de l'invention les bits à transmettre, à l'aide de la mémoire (5) et du générateur pseudo-aléatoire (6). L'unité centrale (7) est aussi reliée à un modulateur (8), qui transforme les bits à transmettre en symboles, les bits étant éventuellement protégés par un code correcteur d'erreurs approprié. Le modulateur (8) envoie les symboles qu'il génère au bloc d'interface avec le canal (9) avec lequel il est relié. Le bloc d'interface avec le canal (9) est chargé d'envoyer les symboles à travers le canal.

L'invention peut être mise en place pour n'importe quel type de canal (4) de communication, hertzien, satellite, fibre optique, paire de cuivre, câble coaxial, courrant porteur ou autre. Le canal peut avoir n'importe quelle caractéristique (canal AWGN, canal de Rayleigh,...).

La figure 3 représente sous forme d'un schéma bloc, un mode de réalisation du récepteur (3). Ce récepteur est un équipement électronique, contenant des moyens de stockage d'information et des moyens de traitement de données aptes à effectuer des calculs programmés. Le récepteur contient un bloc d'interface avec le canal (11) relié au canal (3), qui reçoit et traite les données contenues dans le canal et envoyées par l'émetteur. Ce bloc (11) envoie au démodulateur (12) les symboles qu'il reçoit, c'est-à-dire les symboles envoyés par l'émetteur modifiés par les perturbations introduites dans le canal. Le démodulateur (12) effectue un décodage souple des symboles et transmet à l'unité centrale (13) la probabilité pour chaque bit transmis d'être à un. L'unité centrale (13), capable de faire des calculs programmés, est reliée à une ou plusieurs mémoires (10), avec au moins une mémoire non volatile contenant le code exécutable, et à un générateur pseudo-aléatoire (14), identique à celui (6) de l'émetteur. L'unité centrale (13) détermine les données envoyées selon le procédé de l'invention à partir des informations qu'elle reçoit du démodulateur (12), à l'aide du générateur pseudo-aléatoire (14) et de la mémoire (10).

Au cours de l'étape de codage, l'unité centrale (7) de l'émetteur code les données D de taille $Z \leq \log_2(N!)$ par une permutation Pc de taille N. Il utilise une application C, en l'occurrence un algorithme récursif en N étapes suivant pour coder les données à envoyer dans la permutation :

Les données D sont sous la forme d'un nombre entier $U_{n+1}$ inférieur à N! à transmettre. Une liste L d'indices d'emplacement libre est initialisée par la suite des entiers de 1 à N dans l'ordre croissant.

Pour i décroissant de N à 1, soit le reste $V_i$ et le quotient U, de la division entière de $U_{i+1}$ par i. Soit $W_i$ le $(V_i+1)^{ème}$ élément de la liste L. Cet élément est supprimé de la liste L (à l'étape i, la liste possède toujours i élément). L'élément i du vecteur initial est envoyé par la permutation à la position $W_i$ dans le vecteur permuté.

Cet algorithme permet de générer la permutation qui contient les données à envoyer.

Au cours de l'étape suivante, le générateur de pseudo-aléa génère n séquences $B_1$, $B_2$,... $B_n$ de N bits. Ces bits sont ensuite permutés dans l'unité centrale par la permutation Pc déterminée précédemment. Les séquences obtenues sont notées $B'_1$, $B'_2$,... $B'_n$. Une permutation P, fixe ou pseudo-aléatoire peut éventuellement être appliquée aux bits des séquences $B'_1$, $B'_2$,... $B'_n$ à B' pour obtenir les séquences $B''_1$, $B''_2$,... $B''_n$. Le modulateur code alors éventuellement B" à l'aide d'un code correcteur d'erreurs quelconque, par exemple un code convolutif de rendement 1/2 et de longueur de contrainte 7. Il module alors les bits obtenus dans une modulation adaptée au canal, par exemple une BPSK, et envoie l'information dans le canal.

Lors de la réception, le démodulateur du récepteur, après synchronisation et égalisation du canal, démodule le paquet reçu, et applique, le cas échéant, le décodage correcteur d'erreurs en mode souple, fournissant à l'unité centrale pour chaque bit une probabilité d'être à 1. L'unité centrale applique ensuite, sur les paquets, la permutation inverse de celle de P. Le générateur de pseudo aléa lui fournit aussi les séquences $B_1$, $B_2$,... $B_n$. A l'aide des séquences reçues $R_1$, $R_2$,... $R_n$ et des $B_1$, $B_2$,... $B_n$ extraites de Sb, il alimente la reconstruction de la permutation à l'aide de l'algorithme suivant effectué pour chacune des séquences $B_1$, $B_2$,... $B_n$ extraites de Sb et de la séquence reçue correspondante mais permutée par l'émetteur avec la permutation Pc, respectivement $R_1$, $R_2$, ... $R_n$ :

soit l'hypothèse $H_{ij}$ = " le bit numéro i de B est envoyé sur le bit numéro j de B' " avec i et j variant de 1 à N. L'algorithme attribue une valeur positive, en l'occurrence +1, à $H_{ij}$ si le bit numéro i de B prend la même valeur que le bit numéro j de B' et négative, en l'occurrence -1, sinon. Ces valeurs peuvent dépendre de la confiance attribuée à l'information reçue.

Les matrices $H^K$ obtenues pour chacun des couples $(B_1, R_1)$, $(B_2, R_2)$... $(B_n, R_n)$ sont ensuite additionnées entre elles pour former la matrice H.

L'algorithme évalue alors pour chaque ligne d'indice *i* fixé de la matrice H, les deux maxima des $H_{ij}$, $H_i^1$ et $H_i^2$ avec $H_i^1 > H_i^2$. Si $H_i^1 - H_i^2$ est supérieur à un paramètre Y de seuil alors on note j l'indice de H pour lequel $H_i^1$ est atteint, i.e. $H_i^1 = H_{ij}$. Pour cette colonne d'indice fixé *j* de H, on évalue les deux maxima des $H_{ij}$, $H_j^1$ et $H_j^2$ avec $H_j^1 > H_j^2$. Si $H_j^1 - H_j^2$ est supérieur à un paramètre Y de seuil alors l'algorithme conclut que la permutation envoie le bit i de B sur le bit j de B'. L'algorithme s'arrête lorsqu'une décision a été prise pour tous les bits.

Une fois que l'unité centrale a retrouvé la permutation initiale Pc, elle retrouve les données D codées par l'émetteur à l'aide de l'algorithme suivant correspondant à l'application $C^{-1}$ qui est l'inverse de l'application C :

Les données ont été codées dans une permutation Pc conformément à l'algorithme précité. La permutation est caractérisée par la liste des $(W_1, W_2 ... W_i, W_j, .... W_N)$ l'élément i étant envoyé à l'emplacement $W_i$ par la permutation. Une liste $L_i$ est établie de la manière suivante : l'élément $L_i$ est égal à $W_i$ auquel on soustrait le nombre de $W_j$ inférieur ou égal à $W_i$ pour $j \geq i$.

Le nombre correspondant aux données initiales est reconstruit de la manière suivante : $A_0 = 0$, et pour i croissant de 1 à N, $A_i$ est l'addition de $L_i$ et de $A_{i-1}$ multiplié par i.

Le résultat $A_N$ correspond aux données codées dans la permutation. Ce résultat peut être vérifiée à l'aide d'un code détecteur d'erreurs présent dans les données codées. Si une erreur est détectée, cela veut dire que la permutation retrouvée n'est pas la bonne, et il faut donc attendre de recevoir plus d'information pour retrouver la bonne permutation. S'il existe une voie retour, il peut envoyer un acquittement à l'émetteur, qui peut alors envoyer de nouvelles données. Un exemple simplifié de l'invention est décrit ci après.

On suppose que la permutation Pc est d'ordre N=8 et que l'on veuille envoyer la valeur 22796 par la permutation. Selon l'algorithme de codage de l'information dans une permutation, on calcule la permutation correspondante, ayant les coefficients suivants :

Pc= (6,7,2,3,4,8,1,5). Etant d'ordre 8, elle permet donc de coder un message D de taille $Z \leq \log_2(N!)$ bits de données soit 14 bits et on suppose aussi qu'au niveau de l'émetteur, les séquences $B_i$ ne subissent que la permutation Pc donc ni permutation pseudo-aléatoire ni code correcteur.

N étant égal à 8, le nombre n minimal de séquences $B_i$ devant être extraites de Sb est:

$n = \log_2 (8) = 3$.

Soit :

$B_1 = (1 ; 0 ; 1 ; 0 ; 0 ; 1 ; 0 ; 1)$
$B_2 = (0 ; 0 ; 1 ; 0 ; 1 ; 0 ; 1 ; 1)$
$B_3 = (1;1;1;0;0;0;1;0)$

La permutation Pc est ensuite appliquée, par l'émetteur à chacune de ces séquences de sorte que :

- la première valeur de Bi devienne la sixième valeur de B'i,
- la seconde valeur de Bi devienne la septième valeur de B'i,
- la troisième valeur de Bi devienne la deuxième valeur de B'i,
- la quatrième valeur de Bi devienne la troisième valeur de B'i,
- la cinquième valeur de Bi devienne la quatrième valeur de B'i,
- la sixième valeur de Bi devienne la huitième valeur de B'i.
- la septième valeur de Bi devienne la première valeur de B'i,
- la huitième valeur de Bi devienne la cinquième valeur de B'i,

On obtient ainsi les séquences permutées B'i suivantes :

$B'_1 = (0;1;0;0;1;1;0;1)$
$B'_2 = (1;1;0;1;1;0;0;0)$
$B'_3 = (1;1;0;0;0;1;1;0)$

Le récepteur doit retrouver les coefficients de la permutation Pc à partir des vecteurs Bi qu'il a déterminé en synchronisation avec l'émetteur, et des séquences $R_i$ reçues. On suppose que les séquences reçues le sont sans erreur donc $R_i = B'_i$.

Pour chaque couple de séquences $(B_1, R_1, (B_2, R_2), (B_3, R_3)$, et à partir de l'hypothèse $H_{ij}$ = " le bit numéro i de B est envoyé sur le bit numéro j de R " avec i et j variant de 1 à N. L'algorithme attribue une valeur positive, en l'occurrence +1, à $H_{ij}$ si le bit numéro i de B prend la même valeur que le bit numéro j de R et négative, en l'occurrence -1, sinon, et les moyens de traitement du récepteur déterminent les matrices respectives $H^1$, $H^2$, $H^3$ suivantes :

$$H^1 = \begin{matrix}
-1 & 1 & -1 & -1 & 1 & 1 & -1 & 1 \\
1 & -1 & 1 & 1 & -1 & -1 & 1 & -1 \\
-1 & 1 & -1 & -1 & 1 & 1 & -1 & 1 \\
1 & -1 & 1 & 1 & -1 & -1 & 1 & -1 \\
1 & -1 & 1 & 1 & -1 & -1 & 1 & -1 \\
-1 & 1 & -1 & -1 & 1 & 1 & -1 & 1 \\
1 & -1 & 1 & 1 & -1 & -1 & 1 & -1 \\
-1 & 1 & -1 & -1 & 1 & 1 & -1 & 1
\end{matrix}$$

$$H^2 = \begin{matrix}
-1 & -1 & 1 & -1 & -1 & 1 & 1 & 1 \\
-1 & -1 & 1 & -1 & -1 & 1 & 1 & 1 \\
1 & 1 & -1 & 1 & 1 & -1 & -1 & 1 \\
-1 & -1 & 1 & -1 & -1 & 1 & 1 & 1 \\
1 & 1 & -1 & 1 & 1 & -1 & -1 & 1 \\
-1 & -1 & 1 & -1 & -1 & 1 & 1 & 1 \\
1 & 1 & -1 & 1 & 1 & -1 & -1 & 1 \\
1 & 1 & -1 & 1 & 1 & -1 & -1 & 1
\end{matrix}$$

$$H^3 = \begin{matrix}
1 & 1 & -1 & -1 & -1 & 1 & 1 & -1 \\
1 & 1 & -1 & -1 & -1 & 1 & 1 & -1 \\
1 & 1 & -1 & -1 & -1 & 1 & 1 & -1 \\
-1 & -1 & 1 & 1 & 1 & -1 & -1 & 1 \\
-1 & -1 & 1 & 1 & 1 & -1 & -1 & 1 \\
-1 & -1 & 1 & 1 & 1 & -1 & -1 & 1 \\
1 & 1 & -1 & 1 & 1 & -1 & -1 & 1 \\
-1 & -1 & 1 & 1 & 1 & -1 & -1 & 1
\end{matrix}$$

En faisant la somme des trois matrices $H^1$, $H^2$ et $H^3$ on obtient la matrice H suivante :

$$H = \begin{array}{rrrrrrrr}
-1 & 1 & -1 & -3 & -1 & 3 & 1 & 1 \\
1 & -1 & 1 & -1 & -3 & 1 & 3 & -1 \\
1 & 3 & -3 & -1 & 1 & 1 & -1 & -1 \\
-1 & -3 & 3 & 1 & -1 & -1 & 1 & 1 \\
1 & -1 & 1 & 3 & 1 & -3 & -1 & -1 \\
-3 & -1 & 1 & -1 & 1 & 1 & -1 & 3 \\
3 & 1 & -1 & 1 & -1 & -1 & 1 & -3 \\
-1 & 1 & -1 & 1 & 3 & -1 & -3 & 1
\end{array}$$

Nous prendrons le seuil Y égal à 1. Cette matrice présente, dans chaque ligne, deux maxima de valeurs 3 et 1, dont la différence, 3-1 =2, est supérieur au seuil égal à 1. Il est en est de même pour chacune des colonnes. Ainsi, dans la première ligne, la valeur maximale, en l'occurrence 3, occupe la sixième colonne donc le premier coefficient de la permutation est 6. Dans la seconde ligne, la valeur maximale, en l'occurrence 3, occupe la septième colonne donc le deuxième coefficient de la permutation est 7 etc...

Ainsi, le récepteur retrouve la permutation Pc = (6,7,2,3,4,8,1,5).

Dans le cas où les séquences Ri présentent des erreurs, il pourra alors être nécessaire de traiter davantage de séquences donc un nombre plus grand que $\log_2(N)$.

Lorsque la permutation Pc a été retrouvée par le récepteur, ce dernier retrouve les données à l'aide de l'algorithme de décodage des données codées dans une permutation. Ainsi, le vecteur de données D (ici 22796) est aussi retrouvé.

Lorsque le nombre de bits utilisés pour envoyer les données dans une trame est inférieur à la taille de la permutation N, deux méthodes peuvent être utilisées pour envoyer l'information :

Ou bien le permuté est envoyé par morceau, chaque trame contenant un morceau, et si une trame n'est pas reçue, les bits correspondant sont considérés comme des effacements. Exemple de chaîne de traitement correspondante : codage de l'information dans une permutation Pc de taille N adaptée selon l'étape de codage ; génération d'une séquence pseudo aléatoire de taille N. Mélange par la permutation Pc. Mélange par une permutation P pseudo-aléatoire.. Découpage en plusieurs morceaux et codage convolutif.

Ou bien à chaque trame, un permuté de taille N est généré, et le nombre de bits à envoyer sont sélectionnés pseudo-aléatoirement dans le permuté, le reste du permuté n'étant pas envoyé. Cette méthode n'est à privilégier que si le nombre de bits M utilisés pour envoyer des données dans la trame est très légèrement inférieur à N, taille de la permutation.

Par ailleurs, si la transmission de données n'est pas en diffusion, mais est effectuée en point à point, et si le récepteur dispose d'une voie retour, il est possible d'utiliser le procédé avec un protocole un peu différent : l'émetteur envoie des données à travers le canal en utilisant le procédé, et le récepteur envoie par la voie retour un acquittement de la réception des données quand il a réussi a retrouver la permutation. L'émetteur peut alors envoyer de nouvelles données.

D'autre part, il est aussi possible d'envoyer la permutation à travers plusieurs canaux de communications simultanés. L'étape de codage par la permutation Pc est faite pour l'ensemble des canaux, la même permutation est utilisées dans tous les canaux. L'étape de génération de séquences $B_1...B_n$ est faite pour chaque canal avec un générateur de pseudo-aléa différent. Lors de la réception, chaque canal reçoit un paquet, mais les paquets sont mis dans un même tableau pour tous les canaux et l'étape de détermination de la permutation Pc puis des données D est faite pour l'ensemble des canaux. Si ces canaux sont de performances identiques, le temps pour recevoir les informations sera lors divisé par le nombre de canaux utilisés.

Par exemple il est possible d'utiliser l'invention pour envoyer de l'information avec les technologies à plusieurs antennes (MIMO ou MISO, Multiple Input, Multiple Output ou Multiple Input, Single Output). Chaque antenne d'émission utilise un code d'étalement qui lui est propre, l'information envoyée est codée dans la même permutation pour toutes les antennes, par contre les vecteurs pseudo aléatoire B sont différents pour chaque antenne, ce qui permet de profiter au mieux de la diversité.

Dans une autre variante de réalisation, l'envoi de l'information avec de la diversité peut provenir de modulations ayant plusieurs fréquences porteuses, comme l'OFDM. Dans ce cas une même donnée peut être envoyée à travers les différents canaux correspondant aux différentes fréquences de l'OFDM, de la même manière que dans le cas de l'envoi de la permutation à travers plusieurs canaux de communication simultanés. La capacité de la liaison sera alors l'agrégation des capacités de tous les liens, sans avoir besoin de voie retour pour ajuster la quantité d'information envoyée pour chaque fréquence à la qualité de chaque canal monofréquence. L'existence d'une voie retour peut en revanche être mise à profit pour ajuster le débit global à la qualité globale de la liaison. Si le récepteur n'a pas réussi à retrouver les données, il va le signaler à l'émetteur qui baissera le débit et enverra des informations complémentaires pour retrouver les données qui ont été envoyées précédemment.

En cas d'utilisation de ce procédé pour diffuser l'information à plusieurs récepteurs, chaque récepteur enverra la qualité global de la liaison à l'émetteur, qui ajustera le débit sur le récepteur ayant la plus mauvaise liaison mais de manière globale, alors que dans un mécanisme classique, il aurait fallu le faire pour chaque fréquence, et donc le débit aurait été largement diminué.

De nombreuses modifications peuvent être apportées aux variantes de réalisation décrites précédemment sans sortir du cadre de l'invention. Ainsi, n'importe quelle application C peut être utilisée, du moment où elle est inversible, donnant alors l'application $C^{-1}$ et où elle est apte à associer à des données D les coefficients d'une permutation.

**Revendications**

1. Procédé d'émission d'un message numérique utilisant un émetteur comportant au moins des moyens de stockage d'information et des moyens de traitement des données, **caractérisé en ce qu'**il comporte au moins une étape de codage de données D, constituant tout ou partie dudit message numérique, et consistant à déterminer une permutation Pc dont les coefficients sont, au moins en partie, fonction des données D.

2. Procédé selon la revendication 1, **caractérisé en ce que** les données D comportent Z bits et **en ce que** la permutation Pc est de longueur N, avec $Z \leq \log_2(N\,!)$.

3. Procédé selon l'une quelconque des revendications 1 et 2, **caractérisé en ce que** l'étape de codage est effectuée par une application inversible C apte à associer, aux dites données D, une permutation Pc.

4. Procédé selon l'une quelconque des revendications 1 à 3, **caractérisé en ce qu'**il comporte une étape ultérieure de génération de n séquences de N bits $(B_1, B_2, ..., B_n)$ prédéfinies ou définies en synchronisation avec un récepteur.

5. Procédé selon la revendication 1, **caractérisé en ce qu'**il comporte une étape de permutation des séquences $(B_1, B_2, ..., B_n)$ par la permutation Pc et une étape de transmission des séquences $(B_1, B_2, ..., B_n)$ permutées.

6. Procédé selon l'une quelconque des revendications 1 à 5, **caractérisé en ce que** les séquences $(B_1, B_2, ..., B_n)$ subissent, en plus de la permutation Pc, une seconde permutation pseudo-aléatoire P et/ou un code correcteur avant leur transmission par l'émetteur.

7. Procédé selon l'une quelconque des revendications 1 à 6, **caractérisé en ce qu'**avant leur transmission, les bits de données permutés et les séquences de bits permutées sont modulés en symboles adaptés au canal de transmission.

8. Procédé selon la revendication 7, **caractérisé en ce qu'**il comporte une étape de transmission des permutés à travers une modulation portant sur plusieurs fréquences porteuses, chaque fréquence porteuse utilisant des séquences de bits permutées distinctes et permutées par la même permutation Pc.

9. Procédé selon l'une quelconque des revendications 1 à 8, **caractérisé en ce qu'**il comporte une étape de transmission des permutés, par morceaux, chaque morceau étant envoyé dans une trame différente.

10. Procédé selon l'une quelconque des revendications 1 à 9, **caractérisé en ce que** les permutés ne sont pas envoyés dans leur totalité, la partie envoyée étant par exemple tirée aléatoirement dans le permuté.

11. Procédé de réception d'un message numérique utilisant un récepteur comportant au moins des moyens de stockage d'information et des moyens de traitement de données, **caractérisé en ce qu'**il comporte une étape de réception de séquences $(R_1, R_2, ..., R_n)$, une étape de détermination des coefficients d'une permutation Pc à partir de ces séquences.

12. Procédé selon la revendication 11 **caractérisé en ce qu'**il comporte une étape de décodage d'une permutation Pc pour retrouver des données D.

**13.** Procédé selon l'une quelconque des revendications 11 et 12, **caractérisé en ce que** les coefficients de la permutation Pc sont déterminés à partir de séquences de bits reçues ($R_1$, $R_2$, ..., $R_n$) et de séquences de bits ($B_1$, $B_2$, ..., $B_n$) prédéfinies ou définies en synchronisation avec un émetteur, lesdites séquences reçues ($R_1$, $R_2$, ..., $R_n$) correspondant respectivement aux séquences ($B_1$, $B_2$, ..., $B_n$) mais ayant été permutées par la permutation Pc.

**14.** Procédé selon la revendication 13, **caractérisé en ce que** la permutation Pc et les séquences reçues et prédéfinies ou définies ($B_k$, $R_k$) sont du même ordre, à savoir d'ordre N.

**15.** Procédé selon l'une quelconque des revendications 11 et 14, **caractérisé en ce que** le nombre n de séquences reçues ($R_1$, $R_2$, ..., $R_n$) est au moins égal à $\log_2(N)$.

**16.** Procédé selon l'une quelconque des revendications 3 à 5, **caractérisé en ce que** les données D sont déterminées en appliquant une application inversible $C^{-1}$ apte à associer, aux coefficients de la permutations Pc, les données D..

**17.** Procédé selon l'une quelconque des revendications 1 à 16, **caractérisé en ce que** la permutation Pc comporte des k indices représentant un motif de détection d'erreurs.

**18.** Dispositif d'émission de données apte à mettre en oeuvre un procédé selon l'une quelconque des revendications 1 à 10 et comportant au moins des moyens de stockage d'information et des moyens de traitement d'informations, **caractérisé en ce qu'**il comporte des moyens aptes à coder de l'information D en une permutation Pc et à générer des séquences de bits ($B_1$, $B_2$, ..., $B_n$) prédéfinies ou définies en synchronisation avec un récepteur et à les permuter par la permutation Pc.

**19.** Dispositif selon la revendication 18, **caractérisé en ce que** le dispositif comporte un générateur pseudo-aléatoire pour générer les séquences ($B_1$, $B_2$, ..., $B_n$).

**20.** Dispositif de réception de données apte à mettre en oeuvre un procédé selon l'une quelconque des revendications 11 à 17 et comportant au moins des moyens de stockage d'informations et des moyens de traitement d'information, **caractérisé en ce qu'**il comporte des moyens aptes à déterminer des coefficients d'une permutation Pc à partir de séquences de bits reçues ($R_1$, $R_2$, ..., $R_n$) et de séquences de bits ($B_1$, $B_2$, ..., $B_n$) prédéfinies ou définies en synchronisation avec un émetteur, lesdites séquences reçues ($R_1$, $R_2$, ..., $R_n$) correspondant respectivement aux séquences ($B_1$, $B_2$, ..., $B_n$) mais ayant été permutées par la permutation Pc et apte à décoder la permutation Pc pour retrouver l'information D.

**21.** Dispositif selon la revendication 20, **caractérisé en ce que** le dispositif comporte un générateur pseudo-aléatoire pour générer les séquences ($B_1$, $B_2$, ..., $B_n$).

Fig.1

Fig.2

Fig. 3

Codage par une permutation de
l'information à transmettre

Génération, modulation et envoi dans
le canal des paquets à transmettre

Réception et traitement de suffisamment
de parties de paquets

Reconstruction de la permutation et
extraction des données transmises

Fig.4

Office européen
des brevets

**RAPPORT DE RECHERCHE EUROPEENNE**

Numéro de la demande

EP 07 29 0010

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | RIVEST R L: "THE RC5 ENCRYPTION ALGORITHM" FAST SOFTWARE ENCRYPTION. INTERNATIONAL WORKSHOP, XX, XX, 1995, pages 86-95, XP000890159 * abrégé * * page 90 - page 91 * | 1-21 | INV. H04L9/18 H04L1/00 |
| X | MOLDOVYAN A A ET AL: "A CIPHER BASED ON DATA-DEPENDENT PERMUTATIONS" JOURNAL OF CRYPTOLOGY, SPRINGER, NEW YORK, NY, US, vol. 15, no. 1, décembre 2002 (2002-12), pages 61-72, XP001077672 ISSN: 0933-2790 * le document en entier * | 1-21 | |
| X | US 2004/146162 A1 (GILBERT HENRI ET AL) 29 juillet 2004 (2004-07-29) * le document en entier * | 1-21 | DOMAINES TECHNIQUES RECHERCHES (IPC) H04L |

Le présent rapport a été établi pour toutes les revendications

| Lieu de la recherche | Date d'achèvement de la recherche | Examinateur |
|---|---|---|
| La Haye | 28 février 2007 | Borges, Pedro |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 29 0010

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

28-02-2007

| Document brevet cité au rapport de recherche | Date de publication | Membre(s) de la famille de brevet(s) | Date de publication |
|---|---|---|---|
| US 2004146162 A1 | 29-07-2004 | EP 1475918 A2 | 10-11-2004 |
| | | FR 2848752 A1 | 18-06-2004 |

EPO FORM P0460

Pour tout renseignement concernant cette annexe : voir Journal Officiel de l'Office européen des brevets, No.12/82

**EP 1 806 868 A1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0960495 A